# EUROPEAN PATENT APPLICATION

(11) **EP 3 333 892 A1**
(43) Date of publication of application: **13.06.2018**
(21) Application number: 16203173.6
(22) Date of filing: 09.12.2016
(51) Int. Cl.: H01L 27/146

(54) **METHOD TO PRODUCE A RUGGEDIZED PACKAGE OF AN IMAGE SENSOR**

(71) Applicant: ams AG, 8141 Unterpremstätten (AT)
(72) Inventor: de Kerckhove, Alexandre, 1970 Wezembeek-Oppem (BE)
(74) Representative: Epping - Hermann - Fischer

(57) **Abstract**

A method to produce a ruggedized package (1) of an image sensor comprises a step of producing a plurality of image sensors (100a, ..., 100n), a step (S3, S4) of providing a supporting substrate (10) and placing the plurality of the image sensors (100a, ..., 100n) on the supporting substrate (10) such that the image sensors (100a, ..., 100n) are located spaced apart from each other on the supporting substrate (10), a step (S5) of filling a spacing (20) between the image sensors (100a, ..., 100n) on the supporting substrate (10) with a molding material (200), a step (S6) of delaminating the arrangement of the plurality of the image sensors (100a, ..., 100n) from the supporting substrate (10), and a step (S7) of singularizing the arrangement of the plurality of the image sensors (100a, ..., 100n) such that each image sensor (100a, ..., 100n) is surrounded by the molding material (200).

## Description

### Technical Field

The disclosure relates to a method to produce a ruggedized package of an image sensor that may be used in a camera module to take a picture.

### Background

Image sensors may be used in a camera to transform the incident light in an electrical signal. "Fan-in" wafer-level chip-scale packaging of image sensors is an industry-proven technology. It is mainly developed to produce small camera modules that can fit into mobile communication devices. Most of the image sensors in the consumer market are built using this type of packaging.

An image sensor comprises a substrate, for example a silicon substrate, for the chip area. The light sensitive/pixel area is arranged on top of the substrate. The ambient light impinges the light sensitive area through a window element that may be made of glass and is arranged above the light sensitive area. Most of the image sensors today use microlenses that are directly applied on the light sensitive area. The use of microlenses implies that the package must leave an air gap above those microlenses. To achieve this, a damming material is usually dispensed around the light sensitive area to create a spacing/cavity between window element and the focal plane of the microlenses.

The damming material forms a cavity wall between the outer environment of the image sensor and the cavity inside the image sensor chip. The issue with such a construction is its limited reliability towards moisture penetration, preventing the spread of these sensors to applications requiring higher level of reliability, for example, automotive applications. Environmental tests on such image sensors show that reliability failures occur due to the penetration of moisture inside the cavity between the glass and the image sensor chip.

Micro-cracks cannot be prevented from forming in the damming material due to mechanical stress. As a consequence, small paths are formed in the cavity wall through which moisture can enter inside the cavity between the glass window and the substrate of the image sensor. The penetration of moisture inside the interface between the window element and the substrate of the image sensor causes the stack of the substrate, the light sensitive area and the window element to begin to delaminate and thus the package is broken.

There is a need to provide a method to produce a ruggedized package of an image sensor that is suited to seal the cavity of the image sensor between the light sensitive/pixel area and the window element arranged spaced apart above the light sensitive area against the penetration of moisture.

An embodiment of a method to produce a ruggedized package of an image sensor that allows to seal the image sensor against the penetration of moisture into a cavity between the light sensitive are, also known as the image sensor/pixel area, and the window element is specified in claim 1.

According to the method to produce a ruggedized package of an image sensor, a plurality of image sensors is produced. In a next step, the plurality of image sensors is placed on a supporting substrate such that the image sensors are located spaced apart from each other on the supporting substrate. A spacing between the image sensors on the supporting substrate is filled with a molding material. In a subsequent step the arrangement of the plurality of the image sensors that are surrounded by the molding material are delaminated from the supporting substrate. In a final step the plurality of the image sensors is singularized such that each image sensor is surrounded by the molding material.

According to an embodiment of the method to produce the ruggedized package of the image sensor, the plurality of the image sensors may be produced by using "fan-in" wafer-level chip-scale packaging. According to this manufacturing technique, a substrate, for example a silicon substrate, is provided on which a light-sensitive area, i.e. the image sensor/pixel area, is arranged. The substrate includes components of an integrated circuit to provide signal processing of the optical/electrical signals received from the light-sensitive area. Microlenses may be directly applied on the light-sensitive area so that incident light is focussed to the underlying light-sensitive area. A window element being transparent for ambient light is arranged above the microlenses and the light-sensitive area. The window element may be made of glass. The ambient light impinges the light-sensitive area through the window element and the microlenses.

The use of the microlenses requires an airgap to be provided between the microlenses and the window element. For this purpose, a carrying element is provided on top of the substrate, for example by depositing a damming material around the light-sensitive area. The window element is arranged on the carrying element so that a spacing/cavity is provided between the focal plane of the microlenses and the window element.

The fan-in wafer-level packaging of such an image sensor comprises the bonding of the substrate with the light-sensitive area and the microlenses to the window element on a wafer basis. In a next step of the fan-in wafer-level packaging the produced image sensor wafer is thinned down, and external connections such as (solder) bumps are arranged on the back side of the substrate. The integrated circuit of the substrate is connected to the external connections by a redistribution layer. Through redistribution and bumping a BGA package can be made. The chip-scale packages provided on wafer level are then singularized.

The singularized image sensors may be arranged on a supporting substrate by using a pick-and-place method. The image sensors may be arranged down or up on the supporting substrate. That means that the image sensor chips are arranged on the supporting substrate with the window element directly placed on the supporting substrate ("window down") or by placing the back side of the substrate with the external connections down on the supporting substrate ("window up").

In a next step the spacing between the image sensors is filled by the molding material. For this purpose, a film-assisted molding technique can be used. The mold tool is configured such that the molding material is filled in between the plurality of the image sensors located on the supporting substrate, i.e. in the spacing/gaps between the image sensors. The molding tool may be configured such that the lateral sides of each image sensor arranged on the supporting substrate is embedded in the molding material, but the bottom side of the image sensors that includes the external connections are not covered by the molding material, when the image sensor chips are arranged in the "window down"-configuration on the supporting substrate.

The method step used to fill the spacing between the image sensors on the supporting substrate with the molding material is similar to a fan-out wafer-level packaging technique that comprises a step of reconstituting a diced wafer into a round or rectangular shaped panel comprising only known good dies (KGDs) and with a spacing between the dies. The dies are then overmolded and the contacts are redistributed all over the available surface, i.e. the die area and the molding around.

According to the proposed manufacturing method the image sensors may be produced in a first step by a "fan-in" wafer-level chip-scale packaging technology that offers industrial readiness and low cost. After singularizing the image sensors/image sensor chips, the image sensors/image sensor chips are placed on the supporting substrate spaced apart to each other, and the spacing between the image sensors is filled with the molding material. This method step is similar to the fan-out wafer-level packaging technology by overmolding a reconstituted wafer using a film-assisted molding technique.

After delaminating and singularizing the arrangement of the plurality of the image sensors, a packaging of an image sensor is provided, wherein each image sensor is surrounded by the molding material. The image sensor is embedded in the molding material. The molding material covers the lateral sides of the image sensor so that a ruggedized package of an image sensor is provided. The molding material prevents the moisture from penetrating the cavity between the substrate with the light sensitive area and microlenses arranged thereon and the window element of the image sensor.

The molding material provides a sealing around the damming material of the carrying element so that the penetration of moisture inside the air gap of the image sensor through the damming material of the carrying element can be avoided. The method allows to produce a ruggedized package of an image sensor that can be used for market applications requiring a high level of reliability. A ruggedized package as produced by the proposed method can offer wafer-level packaging of larger dies, without limitation in its reliability level.

### Brief Description of the Drawings

Figure 1 illustrates method steps of a method to produce a ruggedized wafer-level package of an image sensor;
Figure 2A shows a cross-sectional view of a fan-in wafer-level package of an image sensor;
Figure 2B shows a perspective view of a fan-in wafer-level package of an image sensor;
Figure 3A shows a perspective view of a ruggedized package of an image sensor from a top side; and
Figure 3B shows a perspective view of a ruggedized package of an image sensor from a bottom side.

### Detailed Description

The proposed method to produce a ruggedized package of an image sensor as well as a ruggedized package of an image sensor will now be described in more detail hereinafter with reference to the accompanying drawings showing different embodiments of the manufacturing method and the ruggedized package of the image sensor. The manufacturing method and the ruggedized package of the image sensor may, however, be embodied in many different forms and should not be construed as limited to the embodiments set forth herein; rather, these embodiments are provided so that the disclosure will fully convey the scope of the manufacturing method and the ruggedized package of the image sensor to those skilled in the art.

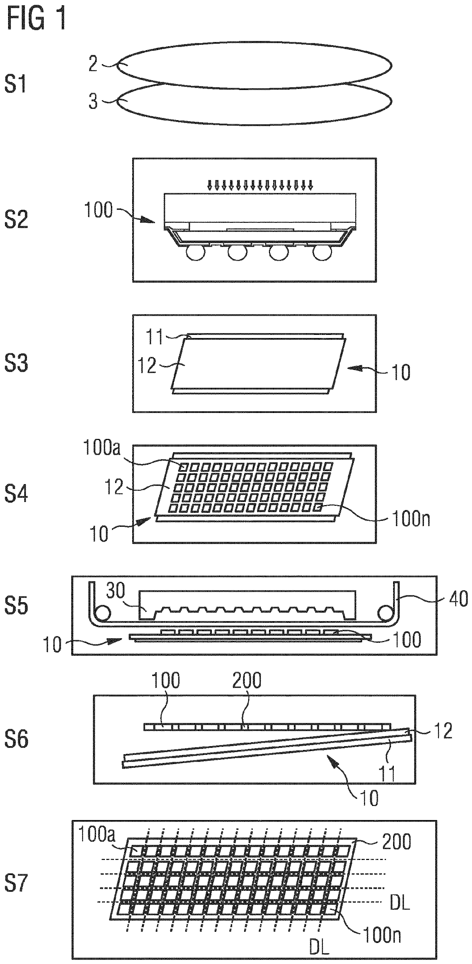

Figure 1 shows different steps of an embodiment of a method to produce a ruggedized wafer-level package that combines parts of a fan-in wafer-level packaging technique with fan-out wafer-level packaging.

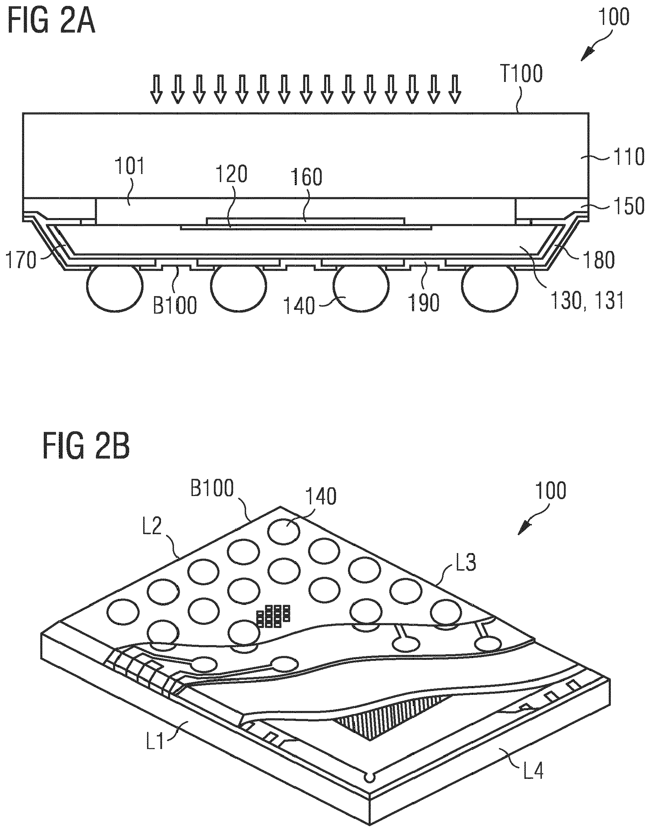

In a step S1 and a step S2 a plurality of image sensors 100a, ..., 100n are produced by using the fan-in wafer-level packaging technology. An image sensor produced by the fan-in wafer-level packaging technique is shown in a cross-sectional view in Figure 2A and in a perspective view from the bottom side in Figure 2B.

In a first step S1 of the method to produce a ruggedized package of an image sensor, an image sensor wafer 2 is bonded to an optical wafer 3. The image sensor wafer 2 may be a silicon wafer. A plurality of image sensors without a window element is realized by the image sensor wafer 2. The optical wafer 3 can be a glass wafer that is used to realize the window element for each of the image sensors.

The components of the image sensor wafer 2 are explained in the following with reference to the embodiment of an image sensor shown in Figures 2A and 2B. The image sensor wafer 2 comprises a substrate 130 on which components of a plurality of the image sensors are arranged. Each image sensor comprises the substrate 130, a light-sensitive area 120 arranged on the substrate 130, and microlenses 160 arranged on the light-sensitive area 120 as well as a damming material forming a cavity wall/carrying element 150 around the respective light-sensitive area 120 of the image sensors.

The substrate 130 comprises for each of the image sensor a respective integrated circuit to process the optical signals received by the respective light-sensitive area 120 of the light sensor, for example to transform an optical signal received by the light-sensitive area 120 in an electrical output signal. The light sensitive area 120 is configured as the image sensor/pixel area of the image sensor. Microlenses 160 are arranged above the light-sensitive area 120 to provide a focal plane to focus incident light onto the underlying light-sensitive area 120. In order to provide a cavity between the image sensor wafer 2 and the glass wafer 3, a damming material forming a cavity wall is dispensed around the light-sensitive area 120 of each of the plurality of image sensors.

In the method step S1, the glass wafer 3 that is used to provide a respective window element 110 at a distance above the substrate 130 for each of the plurality of image sensors is bonded to the image sensor wafer 2. As illustrated in the cross-sectional view of a manufactured fan-in wafer-level packaging of Figure 2A, the glass wafer 3 is placed on the damming material that forms the carrying element 150 to carry the glass wafer at a distance above the image sensor wafer 2.

In the method step S1, the image sensor wafer 2 is then thinned down and via holes, for example, Through-Silicon Vias (TSVs), are provided in the substrate 130 to provide an electrical path to the back side of the image sensor wafer 2. According to another possible embodiment, external electricals connections to the back side of the image sensor wafer 2 can be provided through side contacts, such as shown in the embodiment of the fan-in wafer-level package of Figures 2A and 2B. External connections 140 are provided on the bottom side of the image sensor wafer to electrically contact the image sensor. Through redistribution and bumping a BGA package of an image sensor, as shown in Figures 2A and 2B, is made at the end of method step S1.

In the method step S2 the chip-scale packages that are provided at the end of method step S1 on wafer-level basis are singularized to produce the plurality of the image sensors 100a, ..., 100n.

Figures 2A and 2B show one of these image sensors 100 produced by the fan-in wafer-level packaging technique. After being singularized in the method step S2, each package of an image sensor comprises the substrate 130 and a light-sensitive area, i.e. the image sensor/pixel area, 120 that is arranged on top of the substrate 130. The light-sensitive area 120 is configured to receive light incident through the window element 110 that is arranged spaced apart above the substrate 130. The microlenses 160 are arranged above the light-sensitive area 120. The window element 110 is transparent for ambient light so that the ambient light impinges through the window element 110 to the microlenses 160 which focus the incident light on the light-sensitive area 120.

Figure 2A shows the carrying element 150 provided by the damming material that is deposited around the light-sensitive area 120. The carrying element 150 is arranged on the substrate 130 to carry the window element 110 such that a cavity 101 is provided between the window element 110 and the light-sensitive area 120/the microlenses 160. The cavity is configured as an air gap between the window element 110 and the substrate 130 with the light-sensitive area 120 and the microlenses arranged thereon.

Figures 2A and 2B show the external connections 140 that are arranged on a bottom side B100 of the image sensor 100 that is the bottom side of the substrate 130. The window element 110 is arranged on a top side of the substrate 130. According to the embodiment of the fan-in wafer-level package of the image sensor 100 shown in Figures 2A and 2B, the external connections 140 may be realized as solder bumps. A silicon encapsulant 170 is arranged in direct contact around the bottom side and the lateral sides around the substrate 130. A lead 180 to provide an electrical contact between the external connections on the bottom side of the substrate 130 and the integrated circuit 131 is embodied as a side contact to connect the integrated circuit 131 with the external connections 140. The lead 180 is covered by a lead encapsulant 190. Figure 2B shows the external connections 140 being arranged on the bottom side B100 of the image sensor 100.

In the method step S3, a supporting substrate 10, on which the singularized image sensors 100 are to be placed, is provided. The supporting substrate 10 may comprise a metal carrier 11 being laminated by a double-sided tape 12. The top and the bottom side of the double-sided tape 12 may be provided with an adhesive so that the tape 12 adheres to the metal carrier 11. The supporting substrate 10 is shown in the illustration of the step S3 of Figure 1 having a rectangular shape. It should be noted that the supporting substrate have any suitable other shape, for example a round shape.

In the method step S4 the plurality of the image sensors 100a, ..., 100n are placed on the supporting substrate 10 such that the image sensors 100a, ..., 100n are located spaced apart from each other on the supporting substrate 10. The image sensors 100a, ..., 100n are arranged on the supporting substrate 10 so that a spacing/gap 20 is arranged between each individual image sensor 100a, ..., 100n. The singularized individual image sensors 100a, ..., 100n may be arranged on an adhesive surface of the tape 12 of the supporting substrate 10 by means of a pick-and-place procedure.

According to a possible embodiment of the method to produce the ruggedized package of an image sensor, the image sensors 100a, ..., 100n may be placed on the supporting substrate 10 with their respective top side T100, i.e. with the window element 110, directly arranged on the supporting substrate 10 (placement with "window down"). According to another possible embodiment of the method to produce the ruggedized package of the image sensors, the image sensors 100a, ..., 100n are placed on the supporting substrate 10 with their respective bottom side B100 directly arranged on the supporting substrate 10. In this case the image sensors 100a, ..., 100n are placed with external connections 140 directly arranged on the tape 12 of the supporting substrate 10 (placement with "window up").

In a subsequent manufacturing step S5 the spacing/gap 20 between the individual image sensors 100a, ..., 100n on the supporting substrate 10 are filled with a molding material 200. According to a possible embodiment of the method to produce the ruggedized package of the image sensor, the spacing/gap 20 between the image sensors 100a, ..., 100n is filled with the molding material 200 such that the lateral sides L1, L2, L3 and L4, shown in Figure 2B, of each image sensor 100a, ..., 100n are embedded in the molding material 200. That means that each lateral side L1, ..., L4 of each image sensor 100a, ..., 100n is completely surrounded and sealed by the molding material 200.

According to a possible embodiment of the manufacturing method, the spacing/gap 20 between the image sensors 100a, ..., 100n on the supporting substrate 10 is filled with the molding material 200 such that the bottom side B100 of the image sensors 100a, ..., 100n is not covered by the molding material 200, when the image sensors are placed in the "window-down"-configuration on the supporting substrate 10. The bottom side B100 of a singularized image sensor is shown in Figure 2B. That means that the respective external connections 140 on the bottom side B100 of the image sensors are not covered by the molding material 200.

According to another embodiment of the method to produce a ruggedized package of an image sensor, the spacing/gap 20 between the image sensors 100a, ..., 100n on the supporting substrate 10 is filled with the molding material 200 such that the bottom side B100 of the image sensors 100a, ..., 100n is covered by the molding material 200 except for the tips of the external connections 140. That means that only the tips of the external connections 140 protrude out of the molding material 200 for providing an external connection of the image sensor.

In the case that the image sensors 100a, ..., 100n are placed on the supporting substrate 10 in the "window up"-configuration, the spacing/gap 20 between the image sensors 100a, ..., 100n may be filled with the molding material 200 such that the lateral sides L1, ..., L4 of each image sensor 100a, ..., 100n are embedded in the molding material 200 and the respective top side T100 of the image sensors 100a, ..., 100n is not covered by the molding material 200. That means that each lateral side L1, ..., L4 of the image sensors is completely surrounded by the molding material, and the top side T100, i.e. the window element 110, is free from the molding material 200.

The method step S5 can be performed by using a film-assisted molding technique that is similar to a fan-out wafer-level packaging technique. As illustrated in the method step S5, a molding tool 30 is provided and a film 40 are provided. The film 40 may be pressed against a structured surface of the molding tool 30 by means of a vacuum. The structured surface of the molding tool 30 comprises cavities and protrusions that are formed so that the film 40 allows that certain regions of the image sensors 100a, ..., 100n are filled by the molding material 200 and other regions are protected from being covered by the molding material 200.

The structured surface of the molding tool 30 may be shaped such that the complete bottom surface B100 of each of the image sensors 100a, ..., 100n is not covered by the molding material or that at least the tips of the external connections 140 on the bottom surface B100 are not covered by the molding material 200. The structured surface of the molding tool 30 is in each case shaped such that the spacing/gap 20 between the individual image sensors 100a, ..., 100n are completely filled with the molding material 200. When the image sensors 100a, ..., 100n arranged on the supporting substrate 10 in the "window-up"-configuration, the molding tool 30 may be structured such that the film 40 allows that only the spacing/gap 20 is filled with the molding material 200 and the top side T100 of the image sensors is not covered by the molding material.

In a method step S6, the arrangement of the plurality of the image sensors 100a, ..., 100n being surrounded by the molding material 200 are delaminated from the supporting substrate 10. In a method step S7, the arrangement of the plurality of the image sensors 100a, ..., 100n being surrounded by the molding material 200 is singularized. The arrangement of the plurality of the image sensors 100a, ..., 100n being held together by means of the molding material 200 can be diced along the dicing lines DL illustrated in step 7 of Figure 2. After the singulation, a package of an image sensor is produced, wherein at least the lateral sides L1, ..., L4 of each image sensor 100a, ..., 100n are surrounded by the molding material 200.

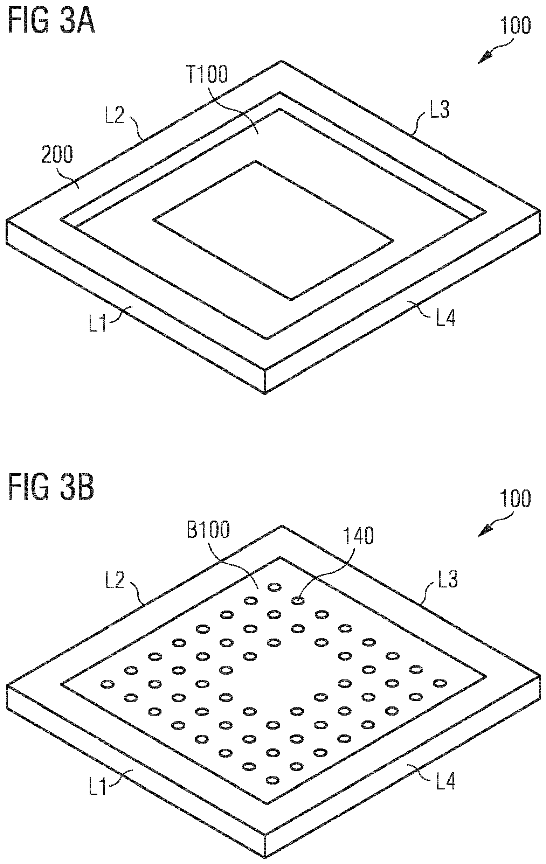

The manufactured ruggedized package 1 of an image sensor 100 after the singulation step S7 is shown from a top side in Figure 3A and from a bottom side in Figure 3B. The ruggedized package of the image sensor 1 comprises the fan-in wafer-level package of the image sensor 100 that is enframed by the molding material 200.

As shown in Figures 3A and 3B, the lateral sides L1, L2, L3 and L4 of the image sensor 100 are completely embedded in the molding material 200, whereas the top surface T100, i.e. the window element 110 and the bottom surface B100 including the external connections 140 are not covered by the molding material and thus are free from the molding material 200. The proposed method provides a ruggedized image sensor package having an improved resistance regarding moisture penetration. The molding material 200 provides a sealing around the fan-in wafer-level package of the image sensor 100 and protects the image sensor 100 from the penetration of moisture in the cavity 101 between the substrate 130 and the window element 110.

### List of Reference Signs

- 1: package of image sensor
- 2: image sensor wafer
- 3: glass wafer
- 10: supporting substrate
- 20: spacing
- 30: molding tool
- 40: film
- 100: image sensor
- 101: cavity
- 110: window element
- 120: light-sensitive area
- 130: substrate
- 140: external connection
- 150: carrying element
- 160: microlenses
- 170: substrate encapsulant
- 180: lead
- 190: lead encapsulant
- S1, ..., S7: method steps

## Claims

1. A method to produce a ruggedized package of an image sensor, comprising:
- producing a plurality of image sensors (100a, ..., 100n),
- placing the plurality of the image sensors (100a, ..., 100n) on a supporting substrate (10) such that the image sensors (100a, ..., 100n) are located spaced apart from each other on the supporting substrate (10),
- filling a spacing (20) between the image sensors (100a, ..., 100n) on the supporting substrate (10) with a molding material (200),
- delaminating the arrangement of the plurality of the image sensors (100a, ..., 100n) being surrounded by the molding material (200) from the supporting substrate (10),
- singularizing the arrangement of the plurality of the image sensors (100a, ..., 100n) such that each image sensor (100a, ..., 100n) is surrounded by the molding material (200).

2. The method of claim 1,
wherein each of the image sensors (100a, ..., 100n) comprises a bottom side (B100) comprising a plurality of external connections (140) to externally contact the respective image sensor (100a, ..., 100n), a top side (T100) comprising a window element (110) being transparent for ambient light, and lateral sides (L1, ..., L4) between the respective top and bottom side (T100, B100) of the image sensors (100a, ..., 100n).

3. The method of claim 2, comprising:
placing the image sensors (100a, ..., 100n) on the supporting substrate (10) such that the image sensors (100a, ..., 100n) are placed with their respective top side (T100) on the supporting substrate (10).

4. The method of claim 3, comprising:
filling the spacing (20) between the image sensors (100a, ..., 100n) with the molding material (200) such that the lateral sides (L1, ..., L4) of each image sensor (100a, ..., 100n) are embedded in the molding material (200).

5. The method of claims 3 or 4, comprising:
filling the spacing (20) between the image sensors (100a, ..., 100n) with the molding material (200) such that the respective bottom side (B100) of the image sensors (100a, ..., 100n) is not covered by the molding material (200).

6. The method of claims 3 or 4, comprising:
filling the spacing (20) between the image sensors (100a, ..., 100n) with the molding material (200) such that the respective bottom side (B100) of the image sensors (100a, ..., 100n) is covered by the molding material (200) except of the tips of the external connections (140) on the respective bottom side (B100) of the image sensors (100a, ..., 100n) that protrude out of the molding material (200).

7. The method of claim 2, comprising:
placing the image sensors (100a, ..., 100n) on the supporting substrate (10) such that the image sensors (100a, ..., 100n) are placed with their respective bottom side (B100) on the supporting substrate (10).

8. The method of claim 7, comprising:
filling the spacing (20) between the image sensors (100a, ..., 100n) with the molding material (200) such that the lateral sides (L1, ..., L4) of each image sensor (100a, ..., 100n) are embedded in the molding material (200) and the respective top side (T100) of the image sensors (100a, ..., 100n) is not covered by the molding material (200).

9. The method of claims 1 to 8, comprising:
using a film assisted molding technique for filling the spacing (20) between the image sensors (100a, ..., 100n) on the supporting substrate (10) with the molding material (200).

10. The method of claims 1 to 9, comprising:
providing a double side tape (12) being laminated on a metal carrier (11) as the supporting substrate (10).

11. A ruggedized package of an image sensor, comprising:
- a window element (110) being transparent for ambient light,
- a light sensitive area (120) to receive the light incident through the window element (110),
- a substrate (130) including an integrated circuit (131) to provide an electrical output signal at external connections (140) of the image sensor (100) in dependence on the incident light,
- a molding material (200),
- wherein the external connections (140) are arranged on a bottom side of the substrate (130) and the window element (110) is arranged on a top side of the substrate (130),
- wherein the molding material is arranged such that at least the lateral sides of the image sensor between the top and the bottom side of the image sensor are embedded in the molding material.

12. The packaging of claim 11,
wherein the bottom side (B100) of the image sensor (100) is not covered by the molding material (200).

13. The packaging of claim 11,
wherein the bottom side (B100) of the image sensor (100) is covered by the molding material (200) except of the tips of the external connections (140) that protrude out of the molding material (200).

14. The packaging of claims 11 to 13,
wherein the top side (T100) of the image sensor (100) is not covered by the molding material (200).

15. The packaging of claims 11 to 14, comprising:
a carrying element (150) that is arranged on the substrate (130) to carry the window element (110) such that a cavity (101) is provided between the window element (110) and the light sensitive area (120).
